(19) Europäisches Patentamt
European Patent Office
Office européen des brevets

(11) **EP 3 211 462 A1**

(12) **EUROPEAN PATENT APPLICATION**
published in accordance with Art. 153(4) EPC

(43) Date of publication:
**30.08.2017 Bulletin 2017/35**

(51) Int Cl.:
*G02B 5/20* (2006.01)   *C09K 11/00* (2006.01)
*C09K 11/02* (2006.01)   *C09K 11/64* (2006.01)
*H01L 33/50* (2010.01)

(21) Application number: **15852065.0**

(22) Date of filing: **22.10.2015**

(86) International application number:
**PCT/JP2015/079771**

(87) International publication number:
**WO 2016/063930 (28.04.2016 Gazette 2016/17)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA**

(30) Priority: **24.10.2014 JP 2014217088**

(71) Applicants:
• **Denka Company Limited**
**Chuo-ku**
**Tokyo 103-8338 (JP)**
• **NGK Insulators, Ltd.**
**Nagoya-shi, Aichi-ken 467-8530 (JP)**

(72) Inventors:
• **SAKAWA Seiichi**
**Tokyo 103-8338 (JP)**
• **MONDEN Kenji**
**Tokyo 103-8338 (JP)**
• **ASAMI Takeshi**
**Tokyo 103-8338 (JP)**
• **OHASHI Tsuneaki**
**Nagoya-shi**
**Aichi 467-8530 (JP)**
• **SHIBATA Kazuyoshi**
**Nagoya-shi**
**Aichi 467-8530 (JP)**

(74) Representative: **Müller-Boré & Partner**
**Patentanwälte PartG mbB**
**Friedenheimer Brücke 21**
**80639 München (DE)**

(54) **WAVELENGTH CONVERTER, LIGHT-EMITTING DEVICE USING SAME, AND PRODUCTION METHOD FOR WAVELENGTH CONVERTER**

(57) The present invention relates to a wavelength converter, to a light-emitting device that uses the wavelength converter, and to a production method for the wavelength converter. The wavelength converter is provided with a light-transmitting substrate (20) and with a thin film (22) that is formed on a surface (20a) of the light-transmitting substrate (20) and that contains a phosphor. A sintered body that constitutes the light-transmitting substrate (20) has an average particle size of 5-40 $\mu$m. The light-transmitting substrate (20) contains at least 10-500 ppm by mass of MgO. The principal component of the phosphor is an a-sialon that is indicated by the general formula $(Ca_{\alpha},Eu_{\beta})(Si,Al)_{12}(O,N)_{16}$ (provided that $1.5 < \alpha+\beta < 2.2$, $0 < \beta < 0.2$, and $O/N \leq 0.04$).

FIG. 1

EP 3 211 462 A1

**Description**

Technical Field

The present invention relates to a wavelength converter, which has a high light transmittance, has high reliability of heat resistance and moisture resistance, and is easily handled in a mounting process or the like, and further relates to a light-emitting device using the wavelength converter and a method for producing the wavelength converter.

Background Art

Light-emitting devices for emitting an amber color light include amber light-emitting LED chips (see Japanese Laid-Open Patent Publication Nos. 2009-158823 and 2013-243092) and light-emitting devices using a red phosphor in combination with a yellow phosphor (see Japanese Laid-Open Patent Publication No. 2011-044738). Although it is very hard to obtain the amber color by using only a YAG phosphor, Japanese Laid-Open Patent Publication No. 2011-044738 tries to obtain the desired amber color light by using a red component-rich nitride phosphor in combination with the YAG phosphor.

Furthermore, an emission color converter containing a glass having a softening point of higher than 500°C and an inorganic phosphor dispersed in the glass is disclosed in Japanese Patent No. 4158012.

Summary of Invention

However, the conventional amber light-emitting LED chip is poor in emission light quantity. Therefore, a large number of the LED chips are required to obtain a sufficient light quantity, and thus an increased production cost and a large installation space are required disadvantageously.

The conventional light-emitting device using the red phosphor in combination with the yellow phosphor has the following disadvantages. The nitride phosphor, which is generally used as the red phosphor, has a lower heat resistance as compared with oxide phosphors. The nitride phosphor is thermally decomposed at a temperature of 500°C or higher, and the light-emitting device using the nitride phosphor has significant limitations on production conditions. Furthermore, since the two types of the phosphors having different temperature properties are used in combination, the chromaticity of the light-emitting device varies largely depending on temperature changes.

The emission color converter described in Japanese Patent No. 4158012 is a sintered body of a mixture powder of the glass and the inorganic phosphor. Therefore, the emission color converter is often cracked in a process of chip cutting, mounting, etc.

In view of the above problems, an object of the present invention is to provide a wavelength converter, which has a high light transmittance, high reliability of heat resistance and moisture resistance, and is easily handled in a mounting process or the like, a light-emitting device using the wavelength converter, and a method for producing the wavelength converter.

[1] According to a first aspect of the present invention, there is provided a wavelength converter comprising a light transmissive substrate and a thin film containing a phosphor and being formed on a surface of the light transmissive substrate, wherein the light transmissive substrate contains a sintered body having an average grain diameter of 5 to 40 $\mu$m, the light transmissive substrate contains at least 10 to 500 ppm by mass of MgO (magnesium oxide), and the phosphor contains, as a main component, an $\alpha$-sialon represented by the general formula:

$$(Ca_{\alpha}, Eu_{\beta}) (Si,Al)_{12}(O,N)_{16} \ (1.5 < \alpha+\beta < 2.2, \ 0 < \beta < 0.2, \ O/N \leq 0.04).$$

[2] In the first aspect, it is preferred that the wavelength converter further comprises a glass as a binder for binding the phosphor.

[3] In this case, the glass has a softening point of 510°C or higher, further preferably 800°C or higher.

[4] It is preferred that the volume ratio of the phosphor/the glass is 20 vol%/80 vol% to 90 vol%/10 vol% where a total volume of the phosphor and the glass is set to 100 vol%.

[5] It is preferred that 25% to 90% by mass of $SiO_2$ (silica) is contained as the glass.

[6] In the first aspect, it is preferred that the light transmissive substrate has a thickness of not less than 0.1 mm and not more than 2.0 mm.

[7] In the first aspect, the thickness of the thin film is preferably 30 to 650 $\mu$m, further preferably 30 to 130 $\mu$m. The effective thickness of the phosphor in the thin film is 3000 to 15000 vol%·$\mu$m. The effective thickness is obtained by multiplying the content of the phosphor in the above phosphor/glass volume ratio by the thickness of the thin film.

[8] In the first aspect, the thermal conductivity of the light transmissive substrate is preferably 20 W/m·K or more, further preferably 30 W/m·K or more.

[9] According to a second aspect of the present invention, there is provided a light-emitting device comprising a light source for emitting an excitation light and a wavelength converter according to the first aspect of the present invention for converting the wavelength of the excitation light to emit a light, wherein the light emitted from the light-emitting device has a chromaticity satisfying the conditions of x ≥ 0.545, y ≥ 0.39, and y-(x-0.12) s 0 in the chromaticity coordinate CIE 1931. It is further preferred that the light has a chromaticity satisfying the conditions of 0.545 ≤ x ≤ 0.580 and 0.41 ≤ y s 0.44. In Japan, an amber color (orange color) for automobile turn signal is defined as satisfying 0.429 ≥ y ≥ 0.398 and z ≤ 0.007 (z = 1-x-y, xyz being chromaticity coordinates) in JIS D 5500. In Europe, the amber color is defined as satisfying y ≥ 0.39, y ≥ 0.79-0.67x, and y ≤ x-0.12 in ECE regulation. In United States, the amber color is defined as satisfying y = 0.39, y = 0.79-0.67x, and y ≤ x-0.12 in SAE J578c and J578d.

[10] In the second aspect, it is preferred that the excitation light emitted from the light source has an emission peak wavelength of 400 to 480 nm.

[11] In the second aspect, it is preferred that an intensity of light emitted from the light source that emits the excitation light toward the wavelength converter has an intensity of 0.01 W/mm$^2$ or more. The intensity of the incident light is normalized by an area of a light-receiving surface of the wavelength converter.

[12] According to a third aspect of the present invention, there is provided a method for producing a wavelength converter according to the first aspect of the present invention comprising a material preparation step of blending raw material powders to prepare a mixture, a compact preparation step of shaping the mixture to prepare a compact, a pre-firing step of firing beforehand the compact to prepare a sintered body precursor, a main firing step of firing the sintered body precursor to prepare a light transmissive substrate, and a thermal attachment step of thermally attaching a phosphor mixture powder to the light transmissive substrate, the phosphor mixture powder being prepared by mixing a phosphor and a glass powder, wherein an organic binder in the compact is decomposed and removed in an oxidizing atmosphere in the pre-firing step, the sintered body precursor is fired at a temperature of 1600°C to 2000°C in a hydrogen atmosphere or a vacuum atmosphere in the main firing step, and the thermally attaching in the thermal attachment step is performed at a temperature of 520°C or higher in an oxidizing atmosphere or a hydrogen-containing atmosphere. The hydrogen-containing atmosphere may be an atmosphere having a hydrogen concentration of 100%, a hydrogen-nitrogen mixture atmosphere, a hydrogen-argon mixture atmosphere, or an air atmosphere with a small amount of hydrogen added.

[13] In the third aspect, it is preferred that the phosphor is such that the internal quantum efficiency is not lowered by a heat treatment in the thermal attachment step. Thus, the phosphor is preferably the above-described phosphor represented by the general formula.

For example, the above α-sialon-containing phosphor may be produced by heat-treating a raw material mixture powder containing silicon nitride, aluminum nitride, a Ca-containing compound, an Eu-containing compound, and the α-sialon at a temperature of 1650°C to 1850°C in a nitrogen atmosphere to generate the α-sialon, and by subjecting the resultant to only a classification treatment to obtain a powder having an average grain diameter of 5 to 50 μm. In this method, the α-sialon is added to the raw material mixture powder, and the powder having an average grain diameter of 5 to 50 μm is obtained only by the classification treatment. The phosphor produced by the method exhibits a small specific surface area, an excellent luminescent efficiency, a low temperature dependence of emission color, and small color changes under high temperature conditions.

The wavelength converter of the present invention has a high light transmittance, a highly reliable heat resistance, and a highly reliable moisture resistance, and can be easily handled in a mounting process or the like. The wavelength converter can be suitably used in various light-emitting devices for emitting the amber color light.

The light-emitting device of the present invention emits the amber color light such that a light transmittance is high, a heat resistance is highly reliable, and a moisture resistance is highly reliable.

The wavelength converter production method of the present invention is capable of producing at low cost the wavelength converter, which has a high light transmittance, a high reliability of heat resistance, and a high reliability of moisture resistance, and can be easily handled in a mounting process or the like.

Brief Description of Drawings

FIG. 1 is a structural view of a light-emitting device with a wavelength converter according to an embodiment.
FIG. 2 is a process flow chart of a method for producing the wavelength converter of the embodiment.
FIG. 3A is a cross-sectional view of a wavelength converter according to a first modification example, and FIG. 3B is a cross-sectional view of a wavelength converter according to a second modification example.
FIG. 4A is a cross-sectional view of a wavelength converter according to a third modification example, and FIG. 4B is a cross-sectional view of a wavelength converter according to a fourth modification example.

FIG. 5A is a cross-sectional view of a wavelength converter according to a fifth modification example, and FIG. 5B is a cross-sectional view of a wavelength converter according to a sixth modification example.

FIG. 6 is a cross-sectional view of a wavelength converter according to a seventh modification example.

FIG. 7 is a view for illustrating an internal quantum efficiency evaluation method using an integrating sphere carried out in Examples 1 to 8 and Comparative Examples 1 to 6.

FIG. 8 is a view for illustrating an energy transmission efficiency evaluation method using an integrating sphere carried out in Examples 1 to 8 and Comparative Examples 1 to 6.

Description of Embodiments

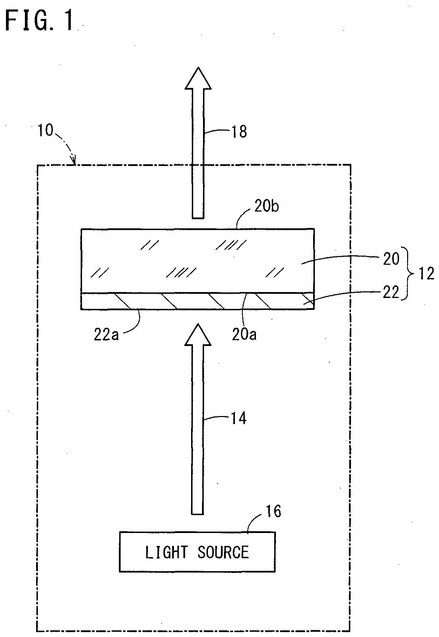

Several embodiments of the wavelength converter, the light-emitting device using the same, and the wavelength converter production method of the present invention will be described in detail below with reference to FIGS. 1 to 8. It should be noted that, in this description, a numeric range of "A to B" includes both the numeric values A and B as the lower limit and upper limit values.

A light-emitting device 10 according to an embodiment has a wavelength converter 12 according to the embodiment and a light source 16 for emitting an excitation light 14 toward the wavelength converter 12. The excitation light 14 from the light source 16 has an emission peak wavelength of 400 to 480 nm. The light source 16 is constituted by an LED (Light Emitting Diode), an LD (Laser Diode), or the like.

The excitation light 14 emitted from the light source 16 onto the wavelength converter 12 has an intensity of 0.01 W/mm$^2$ or more. The intensity of the light indicates the intensity of the incident light normalized by an area of a light-receiving surface of the wavelength converter 12.

As shown in FIG. 1, the wavelength converter 12 of this embodiment acts to change the wavelength of the excitation light 14 coming from the light source 16, thereby generating a light 18 having a different wavelength from the excitation light 14. In this embodiment, the excitation light 14 from the light source 16 (having an emission peak wavelength of 400 to 480 nm) is wavelength-converted to generate the light 18 with an amber color. Specifically, the amber color has a chromaticity satisfying the conditions of $x \geq 0.545$, $y \geq 0.39$, and $y-(x-0.12) \leq 0$ in the chromaticity coordinate CIE 1931.

The wavelength converter 12 has a plate-shaped light transmissive substrate 20 containing an alumina as a main component, and further has a thin film 22 containing a phosphor as a main component. The thin film 22 is formed on a front surface 20a of the light transmissive substrate 20.

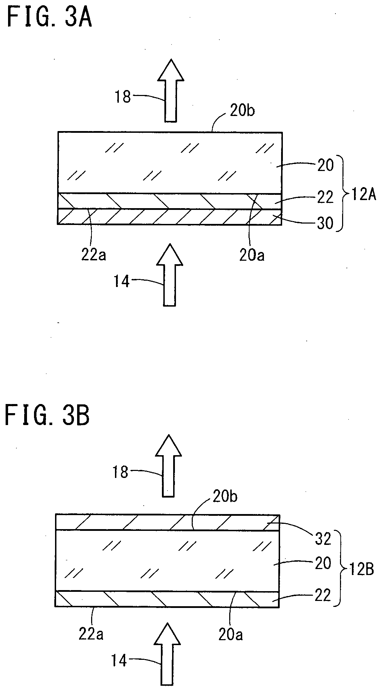

The thin film 22 contains a glass as a binder in addition to the phosphor (i.e. phosphor grains). Although the light transmissive substrate 20 and the thin film 22 have the same sizes in FIG. 1, the sizes are not limited thereto. The sizes may be arbitrarily selected, and the thin film 22 may be smaller than the light transmissive substrate 20. The same applies to FIGS. 3A to 6.

For example, the thickness of the light transmissive substrate 20 is preferably not less than 0.1 mm and not more than 2.0 mm. The porosity of the light transmissive substrate 20 is preferably such that the light transmissive substrate 20 contains a very small amount, e.g. 1 to 1000 ppm by volume, of internal pores. Although the pores may have an adverse effect on the light transmittance, a small amount of the pores acts to improve light diffusion in the light transmissive substrate 20.

A sintered body in the light transmissive substrate 20 preferably has an average grain diameter of 5 to 40 $\mu$m. For example, the average grain diameter may be measured as follows: a portion is arbitrarily selected in a sample; the portion is observed at 200-fold magnification using an optical microscope; the number (N) of crystals located on a line having a length of 0.7 mm is measured in the observed image; and the average grain diameter is calculated using the equation $0.7 \times (4/\pi)/N$.

The thermal conductivity of the light transmissive substrate 20 is preferably 20 W/m·K or more, further preferably 30 W/m·K or more. When the thermal conductivity is 20 W/m·K or more, heat generated in the thin film 22 can be released through the light transmissive substrate 20 to prevent thermal quenching.

Examples of materials for the light transmissive substrate 20 include aluminas, aluminum nitride, spinels, PLZTs (lanthanum-modified lead zirconate titanates), YAGs, $Si_3N_4$, quartzes, sapphires, AlONs, and hard glasses such as PYREX (trademark). The material preferably contains an $Al_2O_3$ component as a main component. The material is preferably a polycrystalline body because the polycrystalline body shows a better bonding property to an oxide glass.

The light transmissive substrate 20 desirably has a flat and high forward transmittance with a low wavelength dependence. The average forward transmittance of the light transmissive substrate 20 at a wavelength of 400 to 700 nm is 60% or more, preferably 75% or more. The wavelength dependence is within the range of the average forward transmittance $\pm$ 15%, preferably within the range of the average forward transmittance $\pm$ 10%. Denseness and crystal grain diameter are important for achieving these properties. For example, a material powder for the light transmissive substrate 20 is doped with 10 to 500 ppm of MgO and fired at a temperature of 1600°C to 2000°C in an atmosphere containing 50% or more of hydrogen to control the sintering. The material powder may be mixed with a rare-earth or group 4A element instead of MgO. A color element such as Fe (iron) or Cr (chromium) lowers the flatness. Therefore, the content of each of the color elements Ti (titanium), V (vanadium), Cr, Mn (manganese), Fe, Co (cobalt), Ni (nickel), and Cu (copper) is preferably 20 ppm or less.

When the average grain diameter is excessively large, chipping tends to happen to a dicer or the like in a cutting process. When the average grain diameter is excessively small, the forward transmittance is lowered. In this case, it is necessary to improve a reflection property of a package to take out the light, thereby resulting in cost increase.

It is preferred that the phosphor for the thin film 22 contains an $\alpha$-sialon as a main component and has an average grain diameter of 5 to 50 $\mu$m. The $\alpha$-sialon is represented by the general formula: $(Ca_{\alpha},Eu_{\beta})(Si,Al)_{12}(O,N)_{16}$ $(1.5 < \alpha+\beta < 2.2, 0 < \beta < 0.2, O/N \leq 0.04)$.

The average grain diameter of the phosphor is a grain size at which the cumulative percent passing (cumulative passing rate) from the smaller grain size side reaches 50% in a volume-based grain size distribution obtained by a laser diffraction scattering grain size distribution measurement method using LS13-320 available from Beckman Coulter, Inc.

With respect to the volume ratio between the phosphor and the glass in the thin film 22 (the volume of each component being obtained by dividing the weight of each component by the relative density of each component), the content of the phosphor is preferably not less than 20 vol% and not more than 90 vol%, further preferably not less than 50 vol% and not more than 90 vol%.

In this manner, the light-emitting device 10 containing the wavelength converter 12 of this embodiment can exhibit an improved luminance while preventing the lowering of the internal quantum efficiency due to the binder for achieving a sufficient adhesion strength between the thin film 22 and the light transmissive substrate 20. Furthermore, the wavelength converter 12 of this embodiment contains no resin components, so that luminance lowering and color unevenness due to resin deterioration do not happen in the light-emitting device 10 equipped with the wavelength converter 12. In addition, luminance lowering due to thermal quenching of the phosphor does not happen because of the heat conduction higher than that of the resin.

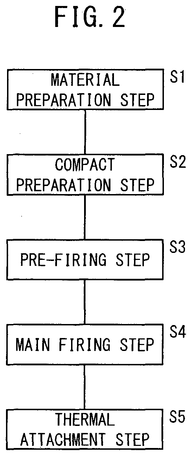

A method for producing the wavelength converter will be described below with reference to FIG. 2.

First, in the material preparation (mixing) step S1, raw material powders are blended to prepare a mixture.

In this step, it is preferred to use a material where at least 10 to 500 ppm of magnesium oxide (MgO) is added as an auxiliary agent to an alumina powder having a BET surface area of 9 to 15 $m^2$/g. For example, a material where an auxiliary agent is added to a high-purity alumina powder having a purity of 99.9% or more (preferably 99.95% or more) is used. For example, an alumina powder available from Taimei Chemicals Co., Ltd. is one example of such a high-purity alumina powder.

Examples of such auxiliary agents include zirconium oxide ($ZrO_2$), yttrium oxide ($Y_2O_3$), lanthanum oxide ($La_2O_3$), and scandium oxide ($Sc_2O_3$) in addition to the magnesium oxide (MgO).

In the compact preparation step S2, the mixture is shaped to prepare a compact. The method of the shaping is not particularly limited, and may be arbitrarily selected from doctor blade methods, extrusion methods, gel casting methods, and the like. It is particularly preferred that the compact is prepared by the gel casting method.

The gel casting methods include the following methods.

(1) A method contains dispersing an inorganic substance powder, a gelling agent of a prepolymer such as a polyvinyl alcohol, an epoxy resin, or a phenol resin, and a dispersing agent in a dispersion medium to prepare slurry, casting the slurry, and three-dimensionally cross-linking the slurry with a cross-linking agent to be a gel, thereby solidifying the slurry.

(2) A method contains chemically bonding a gelling agent and an organic dispersion medium having a reactive functional group to solidify slurry. This method is described in the applicant's patent application, Japanese Laid-Open Patent Publication No. 2001-335371.

In the pre-firing step S3, the compact is pre-fired (prebaked) to obtain a sintered body precursor. The pre-firing is performed in an oxidizing atmosphere to decompose and remove an organic binder in the compact. For example, the pre-firing may be performed in a continuous atmospheric furnace at a temperature of 500°C to 1300°C for a period of 30 minutes to 24 hours.

In the main firing step S4, the sintered body precursor is main-fired to obtain the light transmissive substrate 20. For example, the main firing may be performed in a hydrogen atmosphere or a vacuum atmosphere in a continuous reduction furnace at a temperature of 1600°C to 2000°C for a period of 30 minutes to 24 hours.

In the thermal attachment step S5, a phosphor mixture powder containing a mixture of the phosphor and the glass powder is thermally attached to the light transmissive substrate.

In this step, a paste containing the mixture of the phosphor and the glass is applied to a surface of the light transmissive substrate. The method of applying the paste is not particularly limited but may be selected from known methods such as screen printing, dip coating, and ink-jet methods.

The method of preparing the paste is not particularly limited but may be selected from known methods using a rotation/revolution-stirring-type defoaming mixer, a tri-roll mill, or the like. Also the type of an organic vehicle such as a paste resin or a solvent is not particularly limited. The vehicle may be a known one, and examples of the solvents include terpineols and polyvinyl acetals, and examples of the paste resins include ETHOCELs, acrylic resins, and butyral resins.

In view of improving chemical stability including moisture resistance and the like, the softening point of the glass in the paste is preferably 510°C or higher, further preferably 800°C or higher. Multiple types of glasses may be used as the raw materials.

In view of softening the glass at low temperature, for example, the glass preferably has a lead- or bismuth-based composition. In the case of softening the glass at a temperature of 510°C or higher, the glass may be used that contains 5% by mass or less of alkali metal oxide. Specific examples of the glass compositions include $ZnO-B_2O_3-SiO_2$-, $R_2O-PbO-SiO_2$-, $R_2O-CaO-PbO-SiO_2$-, $BaO-Al_2O_3-B_2O_3-SiO_2$-, and $B_2O_3-SiO_2$-based compositions (wherein R is an alkali metal).

The $\alpha$-sialon represented by the above general formula may be used alone as the phosphor in the paste. Alternatively, a mixture of multiple types of the phosphors may be used in the paste. In this case, the phosphors are mixed to obtain the above-described amber color. Furthermore, a phosphor having a high heat resistance such as an oxide phosphor may be added to adjust the chromaticity.

Several preferred embodiments (modification examples) suitable for further improving emission luminance will be described below with reference to FIGS. 3A to 6. In FIGS. 3A to 6, in each component, the surface on which the excitation light 14 hits is referred to as the front surface, and the surface opposite to the front surface is referred to as the rear surface.

As shown in FIG. 3A, a wavelength converter 12A according to a first modification example has a dichroic film 30 formed on the front surface 22a of the thin film 22. The dichroic film 30 is one type of mirrors which transmits a light having a particular wavelength (e.g. the excitation light 14) and reflects lights having different wavelengths (e.g. the wavelength-converted light 18). In general, the dichroic film 30 is formed by applying a thin film such as a multi-layer dielectric film.

Thus, the dichroic film 30 has a structure provided by alternately stacking high refractive index layers and low refractive index layers. Examples of materials for the high refractive index layer include $TiO_2$ (refractive index = 2.2 to 2.5) and $Ta_2O_5$ (refractive index = 2.0 to 2.3), and examples of materials for the low refractive index layer include $SiO_2$ (refractive index = 1.45 to 1.47) and $MgF_2$ (refractive index = 1.38). The dichroic film 30 contains 5 to 100 layers of the high refractive index layers and 5 to 100 layers of the low refractive index layers, and one layer has a thickness of 50 to 500 nm.

In this example, a part of the light wavelength-converted in the thin film 22 (which may be the light reflected at the interface between the thin film 22 and the light transmissive substrate 20) is reflected by the dichroic film 30 and returned to the light transmissive substrate 20. Consequently, the luminance can be further improved.

As shown in FIG. 3B, a wavelength converter 12B according to a second modification example has an anti-reflection film 32 formed on the rear surface 20b of the light transmissive substrate 20. The anti-reflection film 32 is also called AR coating (Anti Reflection Coating), which is a thin film utilizing light interference for lowering reflection on the rear surface 20b of the light transmissive substrate 20. Examples of materials for the anti-reflection film 32 include $TiO_2$, $SiO_2$, $MgF_2$, and $ZrO_2$.

In this example, the amber color light introduced into the light transmissive substrate 20 is hardly reflected by the rear surface 20b of the light transmissive substrate 20, and is outputted as a forward light, contributing to the improvement of the luminance.

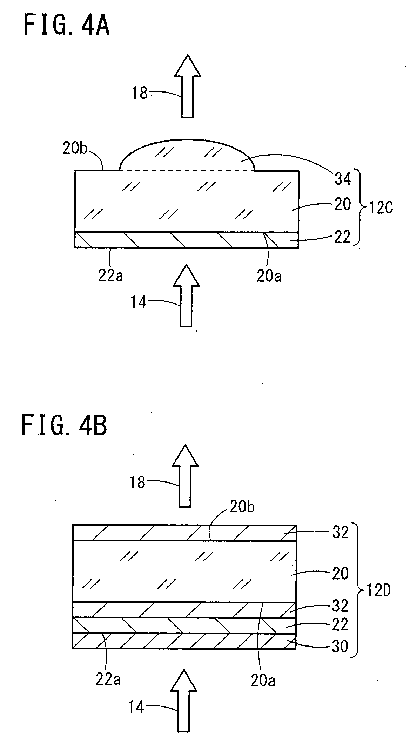

As shown in FIG. 4A, a wavelength converter 12C according to a third modification example includes a lens shape 34, which is formed integrally on the rear surface 20b of the light transmissive substrate 20. The above-described gel casting method may be used for integrally forming the lens shape 34.

With the lens shape 34 integrally formed, the amber color light 18 proceeds toward the lens shape 34 and diffused by the lens shape 34, thereby resulting in an improved light distribution angle.

As shown in FIG. 4B, a wavelength converter 12D according to a fourth modification example has a structure similar to that of the wavelength converter 12A according to the first modification example, but is different in that the anti-reflection film 32 is formed on each of the front surface 20a and the rear surface 20b of the light transmissive substrate 20. In the case of forming the anti-reflection film 32 on the front surface 20a of the light transmissive substrate 20, the light 18 wavelength-converted in the thin film 22 is hardly reflected at the interface between the thin film 22 and the light transmissive substrate 20, and enters the light transmissive substrate 20. In addition, the light entering the light transmissive substrate 20 is not reflected by the rear surface 20b of the light transmissive substrate 20. Consequently, the luminance can be further improved. The anti-reflection film 32 may be formed on either one of the front surface 20a and the rear surface 20b of the light transmissive substrate 20.

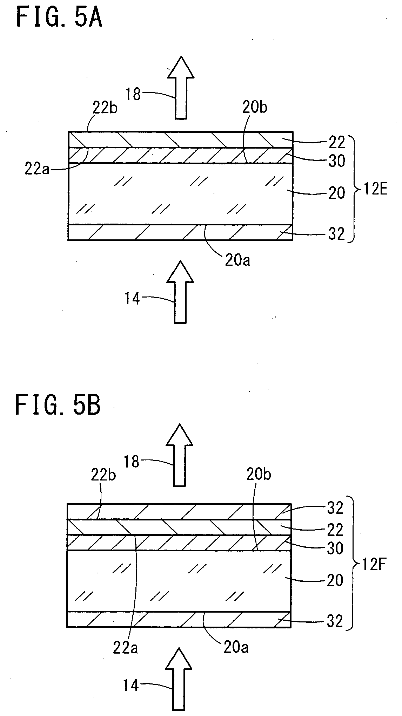

As shown in FIG. 5A, a wavelength converter 12E according to a fifth modification example has the thin film 22 located on the rear surface 20b of the light transmissive substrate 20. In this case, the incident light is diffused in the light transmissive substrate 20, and thus is uniformly introduced into the thin film 22. Some diffused light (the excitation light 14) is converted by the thin film 22 to the light having a different wavelength (the amber color light 18). In addition, the wavelength converter 12E has the dichroic film 30 between the rear surface 20b of the light transmissive substrate 20 and the front surface 22a of the thin film 22, and further has the anti-reflection film 32 formed on the front surface 20a of the light transmissive substrate 20.

In the wavelength converter 12E according to the fifth modification example, the excitation light 14 is not reflected by the front surface 20a of the light transmissive substrate 20, and is diffused and introduced into the thin film 22. Although a part of the light 18 wavelength-converted in the thin film 22 proceeds toward the front surface 22a of the thin film 22, the part is reflected by the dichroic film 30 arranged between the rear surface 20b of the light transmissive substrate 20 and the front surface 22a of the thin film 22, and is returned toward the rear surface 22b of the thin film 22. Consequently, the luminance can be further improved.

As shown in FIG. 5B, a wavelength converter 12F according to a sixth modification example has a structure similar to that of the wavelength converter 12E according to the fifth modification example, but is different in that the anti-reflection film 32 is formed on the rear surface 22b of the thin film 22. In this case, although a part of the light 18 wavelength-converted in the thin film 22 goes toward the front surface 22a of the thin film 22, the part is reflected by the dichroic film 30 and returned toward the rear surface 22b of the thin film 22 in the same manner as the fifth modification example. In particular, in the sixth modification example, the amber color light 18 generated in the thin film 22 is not reflected by the rear surface 22b of the thin film 22, and is emitted to the outside. Consequently, the luminance can be further improved.

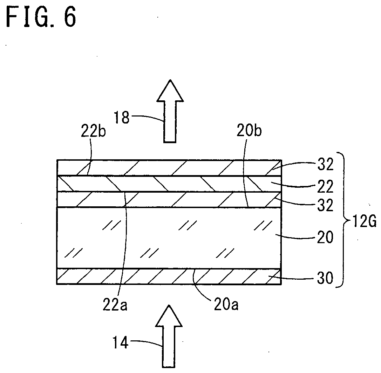

As shown in FIG. 6, a wavelength converter 12G according to a seventh modification example has a structure similar to that of the wavelength converter 12F according to the sixth modification example, but is different in that the dichroic film 30 is formed on the front surface 20a of the light transmissive substrate 20 and the anti-reflection film 32 is formed on the rear surface 20b of the light transmissive substrate 20. In this case, the excitation light 14 is not reflected by the rear surface 20b of the light transmissive substrate 20, and is diffused and proceeds in the thin film 22. Although a part of the amber color light 18 generated in the thin film 22 goes toward the front surface 20a of the light transmissive substrate 20, the part is reflected by the dichroic film 30 formed on the front surface 20a of the light transmissive substrate 20 and returned toward the thin film 22. Consequently, the luminance can be further improved. The anti-reflection film 32 formed on the rear surface 22b of the thin film 22 may be omitted.

Examples

Light-emitting devices according to Examples 1 to 8 and Comparative Examples 1 to 6 were evaluated in terms of chromaticity and optical properties (internal quantum efficiency and energy transmission efficiency). The light-emitting devices of Examples 1 to 8 have structures equal to that of the light-emitting device 10 shown in FIG. 1, and wavelength converters 12 installed in the light-emitting device 10 have structures equal to that of the wavelength converter 12 shown in FIG. 1.

<Example 1>

(Wavelength converter)

A light transmissive substrate 20 having a purity of 99.9%, a relative density of 99.5% or more (measured by the Archimedes method), an average grain diameter of 20 $\mu$m, an outer size of 100 $\times$ 100 mm, and a thickness of 0.5 mm was obtained using a gel casting method described in Japanese Laid-Open Patent Publication No. 2001-335371.

Specifically, a high-purity alumina powder having a purity of 99.99% or more, a BET surface area of 9 to 15 $m^2$/g, and a tap density of 0.9 to 1.0 $g/cm^3$ was doped with auxiliary agents of 300 ppm of an MgO powder, 300 ppm of a $Zr0_2$ powder, and 50 ppm of a $Y_2O_3$ powder. The obtained material powder was shaped by the gel casting method.

The material powder and a dispersing agent were added to and dispersed in a dispersion medium at 20°C, a gelling agent was added thereto and dispersed therein, and a reaction catalyst was further added thereto to obtain slurry. The slurry was cast into a mold and left for 2 hours to convert the slurry to a gel. The gelled compact was taken out from the mold, and was dried at 60°C to 100°C. Then, the compact was degreased and fired at 1800°C for 2 hours in a hydrogen atmosphere (in a main firing step).

A phosphor and a glass were mixed to be a paste with a rotation/revolution-stirring-type defoaming mixer. YL-595A having an average grain diameter of 16 $\mu$m, one of a series of ALONBRIGHT (trademark) manufactured by Denki Kagaku Kogyo Kabushiki Kaisha, was used as a powder of the phosphor. A borosilicate glass having a softening point of 820°C was used in the form of a glass frit.

The phosphor powder, the glass frit, and a predetermined amount of a vehicle were mixed and kneaded uniformly to obtain a desired paste. The amounts of the phosphor and the glass were controlled in such a manner that the volume ratio of phosphor/glass was 60 vol%/40 vol%. Terpineol was used as the vehicle component.

The prepared paste was printed on the light transmissive substrate 20 by a screen printing method. The resultant was dried at 60°C to 100°C in the air, and was fired at 900°C in the air (in a thermal attachment step) to produce the wavelength converter 12 of Example 1. The printing conditions were controlled in such a manner that the thickness (of the thin film 22) was 90 $\mu$m after the firing. The effective thickness of the phosphor in the thin film 22 was 60 vol% $\times$ 90 $\mu$m = 5400 vol%·$\mu$m.

(Light source)

In Example 1, an excitation light 14 having an emission peak wavelength of 460 nm was emitted from a light source 16, and the intensity of the excitation light 14 from the light source 16 was 0.01 W/mm$^2$ on the wavelength converter 12.

<Example 2>

The wavelength converter 12 of Example 2 was produced in the same manner as Example 1 except that the thin film 22 had a thickness of 210 $\mu$m. The effective thickness of the phosphor in the thin film 22 was 60 vol% $\times$ 210 $\mu$m = 12600 vol%·$\mu$m. The above light source 16 described in Example 1 was used also in Example 2.

<Example 3>

The wavelength converter 12 of Example 3 was produced in the same manner as Example 1 except that the volume ratio of phosphor/glass was 90 vol%/10 vol%, and the thin film 22 had a thickness of 60 $\mu$m. The effective thickness of the phosphor in the thin film 22 was 90 vol% $\times$ 60 $\mu$m = 5400 vol%·$\mu$m. The above light source 16 described in Example 1 was used also in Example 3.

<Example 4>

The wavelength converter 12 of Example 4 was produced in the same manner as Example 1 except that the volume ratio of phosphor/glass was 90 vol%/10 vol%, and the thin film 22 had a thickness of 140 $\mu$m. The effective thickness of the phosphor in the thin film 22 was 90 vol% $\times$ 140 $\mu$m = 12600 vol%·$\mu$m. The above light source 16 described in Example 1 was used also in Example 4.

<Comparative Example 1>

The wavelength converter 12 of Comparative Example 1 was produced in the same manner as Example 1 except that the volume ratio of phosphor/glass was 40 vol%/60 vol%, and the thin film 22 had a thickness of 60 $\mu$m. The effective thickness of the phosphor in the thin film 22 was 40 vol% $\times$ 60 $\mu$m = 2400 vol%·$\mu$m. The above light source 16 described in Example 1 was used also in Comparative Example 1.

<Comparative Example 2>

The wavelength converter 12 of Comparative Example 2 was produced in the same manner as Example 1 except that the thin film 22 had a thickness of 300 $\mu$m. The effective thickness of the phosphor in the thin film 22 was 60 vol% $\times$ 300 $\mu$m = 18000 vol%·$\mu$m. The above light source 16 described in Example 1 was used also in Comparative Example 2.

<Example 5>

The wavelength converter 12 of Example 5 was produced in the same manner as Example 1 except that 200 ppm of the MgO powder was used alone as the auxiliary agent, the light transmissive substrate 20 had a thickness of 0.1 mm, and YL-600A having an average grain diameter of 16 $\mu$m, one of a series of ALONBRIGHT (trademark) manufactured by Denki Kagaku Kogyo Kabushiki Kaisha, was used as the phosphor powder. The above light source 16 described in Example 1 was used also in Example 5.

<Example 6>

The wavelength converter 12 of Example 6 was produced in the same manner as Example 5 except that the volume ratio of phosphor/glass was 90 vol%/10 vol%, and the thin film 22 had a thickness of 40 $\mu$m. The effective thickness of the phosphor in the thin film 22 was 90 vol% $\times$ 40 $\mu$m = 3600 vol%·$\mu$m. The above light source 16 described in Example 1 was used also in Example 6.

<Example 7>

The wavelength converter 12 of Example 7 was produced in the same manner as Example 5 except that the glass frit had a softening point of 720°C, and the paste containing the phosphor and the glass was fired at 800°C (in the thermal attachment step). The above light source 16 described in Example 1 was used also in Example 7.

<Example 8>

The wavelength converter 12 of Example 8 was produced in the same manner as Example 7 except that the volume ratio of phosphor/glass was 90 vol%/10 vol%, and the thin film 22 had a thickness of 40 $\mu$m. The effective thickness of the phosphor in the thin film 22 was 90 vol% $\times$ 40 $\mu$m = 3600 vol%·$\mu$m. The above light source 16 described in Example 1 was used also in Example 8.

<Comparative Example 3>

The wavelength converter 12 of Comparative Example 3 was produced in the same manner as Example 7 except that the volume ratio of phosphor/ glass was 40 vol%/60 vol%, and the thin film 22 had a thickness of 60 $\mu$m. The effective thickness of the phosphor in the thin film 22 was 40 vol% $\times$ 60 $\mu$m = 2400 vol%·$\mu$m. The above light source 16 described in Example 1 was used also in Comparative Example 3.

<Comparative Example 4>

The wavelength converter 12 of Comparative Example 4 was produced in the same manner as Example 7 except that the thin film 22 had a thickness of 300 $\mu$m. The effective thickness of the phosphor in the thin film 22 was 60 vol% $\times$ 300 $\mu$m = 18000 vol%·$\mu$m. The above light source 16 described in Example 1 was used also in Comparative Example 4.

<Comparative Example 5>

The wavelength converter 12 of Comparative Example 5 was produced in the same manner as Example 5 except that a red nitride phosphor having an average grain diameter of 16 $\mu$m (composition: RE-625B, crystal structure: SCASN type) was used as the phosphor powder, the glass frit had a softening point of 530°C, the paste containing the phosphor and the glass was fired at 600°C (in the thermal attachment step), and the thin film 22 had a thickness of 100 $\mu$m. The effective thickness of the phosphor in the thin film 22 was 60 vol% $\times$ 100 $\mu$m = 6000 vol%·$\mu$m. The above light source 16 described in Example 1 was used also in Comparative Example 5.

<Comparative Example 6>

The wavelength converter 12 of Comparative Example 6 was produced in the same manner as Example 5 except that a YAG (yttrium aluminum garnet) phosphor having an average grain diameter of 10 $\mu$m and a red nitride phosphor having an average grain diameter of 16 $\mu$m (composition: RE-625B, crystal structure: SCASN type) were used in combination as the phosphor powder. The above light source 16 described in Example 1 was used also in Comparative Example 6.

<Evaluation method>

(Chromaticity)

The wavelength converter 12 was irradiated with the excitation light 14 emitted from the light source 16, and the chromaticity of a light emitted from the light-emitting device 10 was measured by using a total luminous flux measuring instrument of Total Luminous Flux Measurement System HM Series available from Otsuka Electronics Co., Ltd.

(Internal quantum efficiency)

The internal quantum efficiency of each measurement sample (each of the wavelength converters 12 of Examples 1 to 8 and Comparative Examples 1 to 6) was measured by using Fluorescence Spectrophotometer FP-8300 available from JASCO Corporation and a $\phi$60-mm integrating sphere. In the internal quantum efficiency measurement, the excitation light 14 was emitted toward the thin film 22 in all examples.

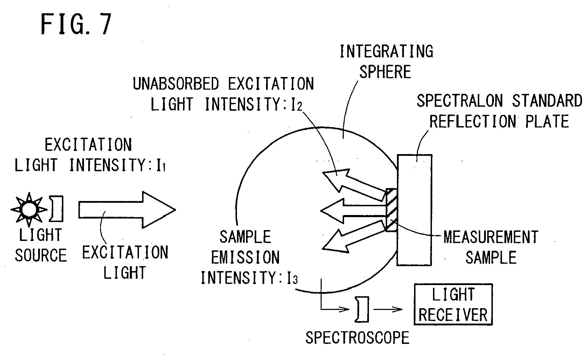

In the measurement of the internal quantum efficiency of the wavelength converter 12, as shown in FIG. 7, the measurement sample (each of the wavelength converters 12 of Examples 1 to 8 and Comparative Examples 1 to 6) was fixed to a Spectralon standard reflection plate, and the measurement sample in this state was directly installed through an excitation port into the integrating sphere to measure a luminescence spectrum under an excitation light at 460 nm.

The intensity $I_1$ of the excitation light (at a wavelength of $460 \pm 20$ nm) was obtained from an excitation light spectrum measured before placing the measurement sample. Furthermore, the intensity $I_2$ of the unabsorbed excitation light (at a wavelength of $460 \pm 20$ nm) and the intensity $I_3$ of the light emitted from the sample (at a wavelength of 480 to 780 nm) were obtained from the luminescence spectrum of the sample. The internal quantum efficiency was calculated using the following equation (1):

$$\texttt{Internal quantum efficiency = } I_3/(I_1-I_2) \quad\texttt{...... (1)}$$

(Energy transmission efficiency)

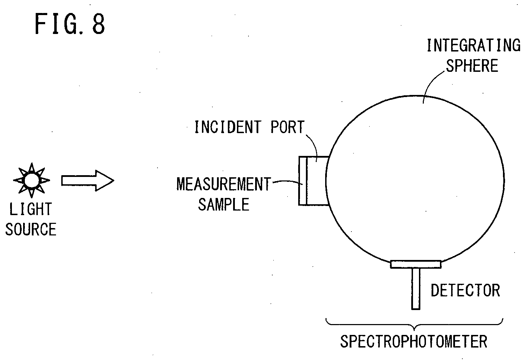

As shown in FIG. 8, the energy transmission efficiency of each of the measurement samples of Examples 1 to 8 and Comparative Examples 1 to 6 was measured by using a spectrophotometer U-4100 available from Hitachi High-Technologies Corporation equipped with a detector and an integrating sphere having an incident port. Also in the energy transmission efficiency measurement, the excitation light 14 was emitted toward the thin film 22 in all examples.

The measurement sample was fixed to the incident port of the integrating sphere, and the front surface of the measurement sample was irradiated with the excitation light having a wavelength of 460 nm from the light source. The detector was used for detecting a light, which was transmitted through the measurement sample and emitted from the back side (the rear surface of the light transmissive substrate) toward the inside of the integrating sphere.

The intensity $I_4$ of the transmission light (at a wavelength of $460 \pm 20$ nm) was obtained from an excitation light spectrum measured before placing the measurement sample. Furthermore, the intensity $I_5$ of the unabsorbed transmission light (at a wavelength of $460 \pm 20$ nm) and the intensity $I_6$ of the light transmitted through the sample (at a wavelength of 480 to 780 nm) were obtained from the luminescence spectrum of the sample. The energy transmission efficiency was calculated using the following equation (2):

$$\texttt{Energy transmission efficiency = } (I_5+I_6)/I_4 \quad\texttt{...... (2)}$$

(Temperature property - chromaticity)

The light-emitting device 10 was placed under the condition of a temperature of 130°C, the excitation light 14 was emitted from the light source 16 toward the wavelength converter 12, and the chromaticity of a light emitted from the light-emitting device 10 was measured by using a total luminous flux measuring instrument of Total Luminous Flux Measurement System HM Series available from Otsuka Electronics Co., Ltd.

The components and evaluation results of Examples 1 to 8 and Comparative Examples 1 to 6 are shown in Tables 1 to 4. The unit "um" shown in Tables 1 to 4 means "$\mu$m".

Table 1

| Items | | | Ex. 1 | Ex. 2 | Ex. 3 | Ex. 4 |
|---|---|---|---|---|---|---|
| Wavelength converter | Substrate | Auxiliary agent | MgO 300 ppm ZrO$_2$ 300 ppm Y$_2$O$_3$ 50 ppm | ← | ← | ← |
| | | Main firing temperature | 1800°C | ← | ← | ← |
| | | Average grain diameter | 20 um | ← | ← | ← |
| | | Thickness | 0.5 mmt | ← | ← | ← |
| | Phosphor | Composition | YL-595A | ← | ← | ← |
| | | Crystal structure | α-Sialon | ← | ← | ← |
| | | Average grain diameter | 16 um | ← | ← | ← |
| | Glass | Softening point | 820°C | ← | ← | ← |
| | | Thermal attachment temperature | 900°C | ← | ← | ← |
| | | Thermal attachment atmosphere | Air | ← | ← | ← |
| | Phosphor layer | Volume ratio A of phosphor | 60 vol% | 60 vol% | 90 vol% | 90 vol% |
| | | Thickness B | 90 um | 210 um | 60 um | 140 um |
| | | Effective thickness A×B (vol%·um) | 5400 | 12600 | 5400 | 12600 |
| | efficiency | Energy transmission efficiency | 20% | 17% | 18% | 15% |
| | | Internal quantum efficiency | 95% | 97% | 94% | 95% |
| Light source | | Excitation light wavelength | 460 nm | ← | ← | ← |
| Light-emitting device | | Chromaticity (25°C) x ≥ 0.545 y ≥ 0.39 y-(x-0.12) ≤ 0 | 0.548 0.419 -0.009 | 0.566 0438 -0.008 | 0.549 0.421 -0.008 | 0.562 0.432 -0.010 |
| | | Light intensity (W/mm$^2$) | 0.01 | 0.01 | 0.01 | 0.01 |
| | Temperature property | Chromaticity (130°C) x ≥ 0.545 y ≥ 0.39 y-(x-0.12) ≤ 0 | 0.565 0.415 -0.030 | - - - | - - - | - - - |

Table 2

| Items | | | Comp. Ex. 1 (Small effective thickness) | Comp. Ex. 2 (Large effective thickness) |
|---|---|---|---|---|
| Wavelength converter | Substrate | Auxiliary agent | MgO 300 ppm ZrO$_2$ 300 ppm Y$_2$O$_3$ 50 ppm | |
| | | Main firing temperature | 1800°C | ← |
| | | Average grain diameter | 20 um | ← |
| | | Thickness | 0.5 mmt | ← |
| | Phosphor | Composition | YL-595A | ← |
| | | Crystal structure | $\alpha$-Sialon | ← |
| | | Average grain diameter | 16 um | ← |
| | Glass | Softening point | 820°C | ← |
| | | Thermal attachment temperature | 900°C | ← |
| | | Thermal attachment atmosphere | Air | ← |
| | Phosphor layer | Volume ratio A of phosphor | 40 vol% | 60 vol% |
| | | Thickness B | 60 um | 300 um |
| | | Effective thickness A×B (vol%·um) | 2400 | 18000 |
| | | Energy transmission efficiency | 38% | 8% |
| | | Internal quantum efficiency | 97% | 91% |
| Light source | | Excitation light wavelength | 460 nm | ← |
| Light-emitting device | | Chromaticity (25°C) x ≥ 0.545 y ≥ 0.39 y-(x-0.12) ≤ 0 | 0.437 0.368 0.051 | 0.563 0.434 -0.009 |
| | | Light intensity (W/mm$^2$) | 0.01 | 0.01 |
| | Temperature property | Chromaticity (130°C) x ≥ 0.545 y ≥ 0.39 y-(x-0.12) ≤ 0 | - - - | - - - |

Table 3

| Items | | | Ex. 5 | Ex. 6 | Ex. 7 | Ex. 8 |
|---|---|---|---|---|---|---|
| Wavelength converter | Substrate | Auxiliary agent | MgO 200 ppm | ← | ← | ← |
| | | Main firing temperature | 1700°C | ← | ← | ← |
| | | Average grain diameter | 8 um | ← | ← | ← |
| | | Thickness | 0.1 mmt | ← | ← | ← |
| | Phosphor | Composition | YL-600 | ← | ← | ← |
| | | Crystal structure | α-Sialon | ← | ← | ← |
| | | Average grain diameter | 16 um | ← | ← | ← |
| | Glass | Softening point | 820°C | ← | 720°C | ← |
| | | Thermal attachment temperature | 900°C | ← | 800°C | ← |
| | | Thermal attachment atmosphere | Air | ← | ← | ← |
| | Phosphor layer | Volume ratio A of phosphor | 60 vol% | 90 vol% | 60 vol% | 90 vol% |
| | | Thickness B | 90 um | 40 um | 90 um | 40 um |
| | | Effective thickness A×B (vol%·um) | 5400 | 3600 | 5400 | 3600 |
| | | Energy transmission efficiency | 28% | 24% | 24% | 22% |
| | | Internal quantum efficiency | 97% | 98% | 98% | 98% |
| Light source | | Excitation light wavelength | 460 nm | ← | ← | ← |
| Light-emitting device | | Chromaticity (25°C) x ≥ 0.545 y ≥ 0.39 y-(x-0.12) ≤ 0 | 0.581 0.407 -0.054 | 0.572 0.403 -0.049 | 0.584 0.412 -0.052 | 0.573 0.402 -0.051 |
| | | Light intensity (W/mm²) | 0.01 | 0.01 | 0.01 | 0.01 |
| | Temperature property | Chromaticity (130°C) x ≥ 0.545 y ≥ 0.39 y-(x-0.12) ≤ 0 | - - - | - - - | - - - | - - - |

Table 4

| Items | | | Comp. Ex. 3 (Small effective thickness) | Comp. Ex. 4 (Large effective thickness) | Comp. Ex. 5 Red nitride phosphor | Comp. Ex. 6 YAG + red nitride phosphor |
|---|---|---|---|---|---|---|
| Wavelength converter | Substrate | Auxiliary agent | MgO 200 ppm | ← | ← | ← |
| | | Main firing temperature | 1700°C | ← | ← | ← |
| | | Average grain diameter | 8 um | ← | ← | ← |
| | | Thickness | 0.1 mmt | ← | ← | ← |
| | Phosphor | Composition | YL-600 | ← | RE-625B | YAG, RE-625B |
| | | Crystal structure | $\alpha$-Sialon | ← | SCASN | YAG + SCASN |
| | | Average grain diameter | 16 um | ← | 16 um | YAG 10 um SCASN 16 um |
| | Glass | Softening point | 720°C | ← | 530°C | 820°C |
| | | Thermal attachment temperature | 800°C | ← | 600°C | 900°C |
| | | Thermal attachment atmosphere | Air | ← | ← | ← |
| | Phosphor layer | Volume ratio A of phosphor | 40 vol% | 60 vol% | 60 vol% | 60 vol% |
| | | Thickness B | 60 um | 300 um | 100 um | 90 um |
| | | Effective thickness A×B (vol%·um) | 2400 | 18000 | 6000 | 5400 |
| | | Energy transmission efficiency | 34% | 5% | 6% | 20% |
| | | Internal quantum efficiency | 96% | 92% | 69% | 72% |
| Light source | | Excitation light wavelength | ← | ← | ← | ← |

(continued)

| Items | | | Comp. Ex. 3 (Small effective thickness) | Comp. Ex. 4 (Large effective thickness) | Comp. Ex. 5 Red nitride phosphor | Comp. Ex. 6 YAG + red nitride phosphor |
|---|---|---|---|---|---|---|
| Light-emitting device | | Chromaticity (25°C) $x \geq 0.545$ $y \geq 0.39$ $y-(x-0.12) \leq 0$ | 0429 0.363 0.054 | 0.572 0.404 -0.048 | 0.513 0.283 -0.110 | 0.569 0.402 -0.047 |
| | | Light intensity (W/mm$^2$) | 0.01 | 0.01 | 0.01 | 0.01 |
| | Temperature property | Chromaticity (130°C) $x \geq 0.545$ $y \geq 0.39$ $y-(x-0.12) \leq 0$ | - - - | - - - | - - - | 0.614 0.382 -0.112 |

As shown in Tables 1 to 4, the wavelength converters of Examples 1 to 8 exhibited the chromaticities within the amber color range of $x \geq 0.545$, $y \geq 0.39$, and $y-(x-0.12) \leq 0$ in the chromaticity coordinate (CIE 1931). Furthermore, the wavelength converters of Examples 1 to 8 had excellent optical properties of the internal quantum efficiencies of 80% or more. In addition, the wavelength converter of Example 1 exhibited the chromaticity satisfying the amber color conditions of $x \geq 0.545$, $y \geq 0.39$, and $y-(x-0.12) \leq 0$ in the chromaticity coordinate (CIE 1931) even under the high temperature (130°C).

Among Examples 1 to 8, the wavelength converters of Examples 5 to 8 had higher internal quantum efficiencies and energy transmission efficiencies than those of the wavelength converters of Examples 1 to 4. The efficiencies may depend on the types of the phosphors, and may depend also on the light transmissive substrates. In Examples 5 to 8, only the MgO was used as the auxiliary agent for producing the light transmissive substrate, the main firing temperature was lower than that of Examples 1 to 4, and the thickness of the light transmissive substrate was smaller than that of Examples 1 to 4. These factors may also contribute to the increase of the efficiencies.

In contrast, the wavelength converters of Comparative Examples 1 and 3 exhibited the chromaticities outside the amber color ranges because of the small effective phosphor thickness of 2400 vol%·μm. Although the wavelength converters of Comparative Examples 2 and 4 exhibited the chromaticities within the amber color ranges, the wavelength converters exhibited the low energy transmission efficiencies of 8% and 5%, lower than the practical-level efficiency of 10%, because of the large effective phosphor thickness of 18000 vol%·μm.

The wavelength converter of Comparative Example 5 used the red nitride phosphor, and therefore exhibited the low energy transmission efficiency of 6%, the low internal quantum efficiency of 69%, and the chromaticity outside the amber color ranges. The wavelength converter of Comparative Example 6 used the combination of the YAG phosphor and the red nitride phosphor, and therefore exhibited the low internal quantum efficiency of 72% although the energy transmission efficiency was 20%. In addition, in Comparative Example 6, the chromaticity was out of the amber color ranges under the high temperature condition (130°C), and thus exhibited poor temperature property.

The wavelength converter, the light-emitting device using the wavelength converter, and the wavelength converter production method of the present invention are not limited to the above-described embodiments, and various changes and modifications may be made therein without departing from the scope of the invention.

**Claims**

1. A wavelength converter comprising
   a light transmissive substrate (20) and
   a thin film (22) containing a phosphor and being formed on a surface of the light transmissive substrate (20), wherein
   the light transmissive substrate (20) contains a sintered body having an average grain diameter of 5 to 40 μm,

the light transmissive substrate (20) contains at least 10 to 500 ppm by mass of MgO (magnesium oxide), and the phosphor contains, as a main component, an $\alpha$-sialon represented by a general formula:

$$(Ca_\alpha, Eu_\beta)(Si, Al)_{12}(O, N)_{16}$$

where $1.5 < \alpha + \beta < 2.2$, $0 < \beta < 0.2$, and $O/N \leq 0.04$.

2. The wavelength converter according to claim 1, further comprising a glass as a binder for binding the phosphor.

3. The wavelength converter according to claim 2, wherein the glass has a softening point of 510°C or higher.

4. The wavelength converter according to claim 2 or 3, wherein the volume ratio of the phosphor/the glass is 20 vol%/80 vol% to 90 vol%/10 vol% where a total volume of the phosphor and the glass is set to 100 vol%.

5. The wavelength converter according to any one of claims 2 to 4, wherein 25% to 90% by mass of $SiO_2$ (silica) is contained as the glass.

6. The wavelength converter according to any one of claims 1 to 5, wherein the light transmissive substrate (20) has a thickness of not less than 0.1 mm and not more than 2.0 mm.

7. The wavelength converter according to any one of claims 1 to 6, wherein the thin film (22) has a thickness of 30 to 650 $\mu$m.

8. The wavelength converter according to any one of claims 1 to 7, wherein the light transmissive substrate (20) has a thermal conductivity of 20 W/m-K or more.

9. A light-emitting device comprising
a light source (16) configured to emit an excitation light (14) and
a wavelength converter (12) according to any one of claims 1 to 8 configured to convert the wavelength of the excitation light (14) to emit a light (18),
wherein
the light (18) emitted from the light-emitting device has a chromaticity satisfying the conditions of $x \geq 0.545$, $y \geq 0.39$, and y-(x-0.12) s 0 in the chromaticity coordinate CIE 1931.

10. The light-emitting device according to claim 9, wherein the excitation light (14) emitted from the light source (16) has an emission peak wavelength of 400 to 480 nm.

11. The light-emitting device according to claim 9 or 10, wherein an intensity of light emitted from the light source (16) that emits the excitation light (14) toward the wavelength converter (12) has an intensity of 0.01 W/mm$^2$ or more.

12. A method for producing a wavelength converter (12) according to any one of claims 1 to 8, comprising
a material preparation step of blending raw material powders to prepare a mixture,
a compact preparation step of shaping the mixture to produce a compact,
a pre-firing step of firing beforehand the compact to produce a sintered body precursor,
a main firing step of firing the sintered body precursor to prepare a light transmissive substrate (20), and
a thermal attachment step of firing and attaching a phosphor mixture powder to the light transmissive substrate (20),
the phosphor mixture powder being prepared by mixing a phosphor and a glass powder,
wherein
an organic binder in the compact is decomposed and removed in an oxidizing atmosphere in the pre-firing step,
the sintered body precursor is fired at a temperature of 1600°C to 2000°C in a hydrogen atmosphere or a vacuum atmosphere in the main firing step, and
the firing and attaching in the thermal attachment step is performed at a temperature of 520°C or higher in an oxidizing atmosphere or a hydrogen-containing atmosphere.

13. The method according to claim 12, wherein the phosphor is such that the internal quantum efficiency is not lowered by a heat treatment in the thermal attachment step.

FIG. 1

# FIG. 2

| | |
|---|---|
| MATERIAL PREPARATION STEP | S1 |
| COMPACT PREPARATION STEP | S2 |
| PRE-FIRING STEP | S3 |
| MAIN FIRING STEP | S4 |
| THERMAL ATTACHMENT STEP | S5 |

# FIG. 3A

# FIG. 3B

# FIG. 4A

# FIG. 4B

# FIG. 5A

# FIG. 5B

FIG. 6

# FIG. 7

INTEGRATING SPHERE

UNABSORBED EXCITATION
LIGHT INTENSITY: $I_2$

SPECTRALON STANDARD
REFLECTION PLATE

EXCITATION
LIGHT INTENSITY: $I_1$

LIGHT
SOURCE  EXCITATION
LIGHT

SAMPLE
EMISSION
INTENSITY: $I_3$

MEASUREMENT
SAMPLE

LIGHT
RECEIVER

SPECTROSCOPE

FIG. 8

INTEGRATING
SPHERE

INCIDENT PORT

MEASUREMENT
SAMPLE

LIGHT
SOURCE

DETECTOR

SPECTROPHOTOMETER

## INTERNATIONAL SEARCH REPORT

| International application No. |
| --- |
| PCT/JP2015/079771 |

A.  CLASSIFICATION OF SUBJECT MATTER
*G02B5/20*(2006.01)i, *C09K11/00*(2006.01)i, *C09K11/02*(2006.01)i, *C09K11/64*
(2006.01)i, *H01L33/50*(2010.01)i

According to International Patent Classification (IPC) or to both national classification and IPC

B.  FIELDS SEARCHED

Minimum documentation searched (classification system followed by classification symbols)
G02B5/20, C09K11/00, C09K11/02, C09K11/64, H01L33/50

Documentation searched other than minimum documentation to the extent that such documents are included in the fields searched
    Jitsuyo Shinan Koho      1922-1996   Jitsuyo Shinan Toroku Koho   1996-2016
    Kokai Jitsuyo Shinan Koho  1971-2016   Toroku Jitsuyo Shinan Koho   1994-2016

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
| --- | --- | --- |
| Y<br>A | JP 2013-247067 A  (Nichia Chemical Industries, Ltd.),<br>09 December 2013 (09.12.2013),<br>claims; paragraphs [0053], [0061], [0066], [0094], [0097], [0119] to [0123], [0164] to [0165], [0183] to [0184], [0193], [0197], [0219] to [0220]<br>& US 2013/0257264 A1<br>claims; paragraphs [0135] to [0137], [0160] to [0164], [0391] to [0394], [0415] to [0416], [0422], [0452] to [0455], [0478], [0482], [0590] to [0598], [0658] to [0660]<br>& EP 2645433 A2      & KR 10-2013-0110101 A<br>& CN 103367611 A | 1-11<br>12-13 |

| ☒ | Further documents are listed in the continuation of Box C. | ☐ | See patent family annex. |
| --- | --- | --- | --- |

| * | Special categories of cited documents: |
| --- | --- |
| "A" | document defining the general state of the art which is not considered    to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search<br>    12 January 2016 (12.01.16) | Date of mailing of the international search report<br>    19 January 2016 (19.01.16) |
| --- | --- |
| Name and mailing address of the ISA/<br>    Japan Patent Office<br>    3-4-3,Kasumigaseki,Chiyoda-ku,<br>    Tokyo 100-8915,Japan | Authorized officer<br><br><br>Telephone No. |

Form PCT/ISA/210 (second sheet) (January 2015)

**INTERNATIONAL SEARCH REPORT**

| International application No. |
|---|
| PCT/JP2015/079771 |

C (Continuation). DOCUMENTS CONSIDERED TO BE RELEVANT

| Category* | Citation of document, with indication, where appropriate, of the relevant passages | Relevant to claim No. |
|---|---|---|
| Y<br>A | JP 2009-096883 A  (Stanley Electric Co., Ltd.),<br>07 May 2009 (07.05.2009),<br>claims; paragraphs [0024], [0046]<br>& US 2010/0208481 A1<br>claims; paragraphs [0030], [0058]<br>& WO 2009/051137 A1    & EP 2202808 A1<br>& CN 101828273 A         & KR 10-2010-0097097 A | 1-11<br>12-13 |
| Y<br>A | WO 2007/004492 A1  (Independent Administrative<br>Institution National Institute for Materials<br>Science),<br>11 January 2007 (11.01.2007),<br>claims<br>& US 2009/0085465 A1<br>claims<br>& JP 5110518 B              & KR 10-2008-0030568 A | 1-11<br>12-13 |
| Y<br>A | JP 2010-268013 A  (Nichia Chemical Industries,<br>Ltd.),<br>25 November 2010 (25.11.2010),<br>paragraph [0065]<br>(Family: none) | 1-11<br>12-13 |
| Y<br>A | JP 2011-009635 A  (Nichia Chemical Industries,<br>Ltd.),<br>13 January 2011 (13.01.2011),<br>paragraph [0040]<br>(Family: none) | 1-11<br>12-13 |
| Y | JP 2010-261048 A  (Sharp Corp.),<br>18 November 2010 (18.11.2010),<br>claims; paragraphs [0054], [0058] to [0059]<br>(Family: none) | 3,5 |
| Y | JP 2012-052061 A  (Nippon Electric Glass Co.,<br>Ltd.),<br>15 March 2012 (15.03.2012),<br>paragraphs [0036], [0070]<br>(Family: none) | 6-7 |
| P,Y | JP 2014-207436 A  (NGK Insulators, Ltd.),<br>30 October 2014 (30.10.2014),<br>claims; paragraphs [0023] to [0039]; fig. 1 to<br>8<br>(Family: none) | 1-13 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2009158823 A
- JP 2013243092 A
- JP 2011044738 A
- JP 4158012 B
- JP 2001335371 A